# EUROPEAN PATENT APPLICATION

(11) **EP 4 443 525 A1**
(43) Date of publication of application: **09.10.2024**
(21) Application number: 22901383.4
(22) Date of filing: 30.11.2022
(51) Int. Cl.: H01L 33/02, H01L 33/22

(54) **METHOD FOR MANUFACTURING BONDED SEMICONDUCTOR WAFER**

(30) Priority: 03.12.2021 JP 2021197075
(71) Applicant: Shin-Etsu Handotai Co., Ltd., Tokyo 100-0004 (JP)
(72) Inventor: ISHIZAKI, Junya, Annaka-shi, Gunma 379-0196 (JP)
(74) Representative: Mooser, Sebastian Thomas
(86) International application number: PCT/JP2022/044259
(87) International publication number: WO 2023/100952

(57) **Abstract**

The present invention is a method for manufacturing a bonded semiconductor wafer, the method includes growing an etching stop layer on a starting substrate, producing an epitaxial wafer by growing an epitaxial layer having a compound semiconductor functional layer on the etching stop layer, forming an isolation groove to form a device in the compound semiconductor functional layer by a dry etching method, performing roughening etching on a surface of the epitaxial layer, being the opposite side of the starting substrate, thereby making surface roughness thereon to have 0.1 um or more in an arithmetic average roughness Ra, bonding a visible light-transmissive substrate to the surface opposite to the starting substrate of the epitaxial wafer via a visible light-transmissive thermosetting bonding material, and removing the starting substrate. This provides the method for manufacturing the bonded semiconductor wafer in which a micro-LED can be made with a suppressed generation of luminance decrease when a micro-LED device is produced on the substrate.

## Description

### TECHNICAL FIELD

The present invention relates to a method for manufacturing a bonded semiconductor wafer.

### BACKGROUND ART

A technique to separate only semiconductor functional layers, such as epitaxial functional layers, from starting substrates and transfer thereof to another substrate is an important technique to mitigate restriction due to physical properties of the starting substrates and to increase the degree of freedom in designing device systems.

In particular, concerning micro-LED devices, transferring the devices staying on the starting substrates to a drive circuit is difficult, and a transferring technique is indispensable. To produce a donor substrate capable of performing the transfer to the drive circuit suitable for the micro-LED device, a technique is necessary, in which an epitaxial functional layer is bonded to a permanent substrate, and then the starting substrate is removed, and thus, the transfer is realized.

Moreover, in the micro-LED device, at the same time as the problem of the donor substrate production, another problem exists in which reducing the micro-LED size generates a luminance decrease.

Patent Document 1 discloses a technique for bonding a semiconductor epitaxial substrate to a temporary supporting substrate via a dielectric layer by thermo-compression and a technique for separating the temporary supporting substrate and an epitaxial functional layer by wet etching.

Patent Document 2 discloses a technique in which an isolation groove is formed to expose a sacrificial layer, and then bonding is performed, and then sacrificial-layer etching is performed, thereby separating a starting substrate.

### CITATION LIST

### PATENT LITERATURE

Patent Document 1: JP 2021-27301 A
Patent Document 2: WO 2014/020906 A1

### SUMMARY OF INVENTION

### TECHNICAL PROBLEM

In a technique disclosed in Patent Document 1, after forming an oxide layer on a surface of an epitaxial wafer to perform temporary support treatment, a starting substrate is delaminated by performing sacrificial layer etching. However, a smaller-sized micro-LED can be realized using this technique, but Patent Document 1 does not disclose any improvement measures for luminance decrease.

In addition, in Patent Document 2, an isolation groove is formed, and then the sacrificial layer etching is performed via the isolation groove. However, a smaller-sized micro-LED can be realized using this technique, Patent Document 2 does not disclose any improvement measures for luminance decrease.

The present invention has been made to solve the above-described problem. An object of the present invention is to provide a method for manufacturing a bonded semiconductor wafer that can be a light-emitting device of small size in which generation of luminance decreases is suppressed when the light-emitting device of small size is produced on a substrate.

### SOLUTION TO PROBLEM

To achieve the object, the present invention provides a method for manufacturing a bonded semiconductor wafer, the method comprising the steps of:
epitaxially growing an etching stop layer on a starting substrate;
producing an epitaxial wafer by epitaxially growing an epitaxial layer having a compound semiconductor functional layer on the etching stop layer;
forming an isolation groove to form a device in the compound semiconductor functional layer by a dry etching method;
performing roughening etching on a surface of the epitaxial layer, being the opposite side of the starting substrate, thereby making surface roughness thereon to have 0.1 um or more in an arithmetic average roughness Ra;
bonding a visible light-transmissive substrate of a different material from a material of the epitaxial layer to the surface opposite to the starting substrate of the epitaxial layer via a visible light-transmissive thermosetting bonding material, and
removing the starting substrate.

By virtue of such a method for manufacturing the bonded semiconductor wafer, roughening etching on a surface of the epitaxial layer (epitaxial growth layer) makes surface roughness of 0.1 um or more in Ra; thus, a device can be transferred, in which luminance decrease of a small-size light-emitting device is suppressed.

In addition, in the inventive method for manufacturing the bonded semiconductor wafer, the roughening etching can be performed before forming the isolation groove, or after forming the isolation groove.

In this way, the roughening etching can be performed before or after the formation of the isolation groove.

In addition, one side of the device can be 100 um or less by forming the isolation groove in the compound semiconductor functional layer.

In this way, as a result of forming the isolation groove in the compound semiconductor functional layer, the present invention is significantly effective, particularly for the suppression of luminance decrease of the light-emitting device to be the device having one side of 100 um or less.

Moreover, the device can be a micro-LED structure having a light emitting layer and a window layer.

The present invention is particularly effective to the device being the micro-LED structure having the light emitting layer and the window layer.

Furthermore, in the inventive method for manufacturing a bonded semiconductor wafer, the roughening etching can be performed using a solution mixed with at least two of acetic acid solutions, hydrofluoric acid solution, and iodine solution.

By using a solution mixed with at least two of these solutions, the surface of the epitaxial layer can be roughened more reliably.

In addition, the visible light-transmissive substrate is preferred to be any one of sapphire, quartz, glass, SiC, LiTaO₃, or LiNbO₃.

Such a visible light-transmissive substrate can be selected to have high transmissivity to a laser in particular; thus, it is suitable as a bonded substrate of the inventive method for manufacturing the bonded semiconductor wafer.

Moreover, it is preferred that the visible light-transmissive thermosetting bonding material is any one or more materials of benzocyclobutene (BCB), silicone resin, epoxy resin, spin-on-glass, polyimide, or fluororesin.

The visible light-transmissive thermosetting bonding materials such as these can be suitably used as bonding materials in the method for manufacturing the bonded semiconductor wafer.

Furthermore, the visible light-transmissive thermosetting bonding material can have a thickness of 0.01 um or more and 0.6 um or less.

Such a thickness of the bonding material can make the thickness distribution of the bonding material relatively small, thus preferable.

### ADVANTAGEOUS EFFECTS OF INVENTION

With regard to the inventive method for manufacturing the bonded semiconductor wafer, roughening etching is performed on the surface of the epitaxial layer (epitaxial growth layer) to make the surface roughness of 0.1 um or more in Ra, thereby it is possible to transfer the device in which the luminance decrease of the small-sized light-emitting device (in particular, the micro-LED device) is suppressed.

### BRIEF DESCRIPTION OF DRAWINGS

FIG. 1 is a schematic cross-sectional view illustrating a part of the first embodiment of a method for manufacturing a bonded semiconductor wafer according to the present invention.
FIG. 2 is a schematic cross-sectional view illustrating another part of the first embodiment of a method for manufacturing a bonded semiconductor wafer according to the present invention.
FIG. 3 is a schematic cross-sectional view illustrating another part of the first embodiment of a method for manufacturing a bonded semiconductor wafer according to the present invention.
FIG. 4 is a schematic cross-sectional view illustrating another part of the first embodiment of a method for manufacturing a bonded semiconductor wafer according to the present invention.
FIG. 5 is a schematic cross-sectional view illustrating another part of the first embodiment of a method for manufacturing a bonded semiconductor wafer according to the present invention.
FIG. 6 is a schematic cross-sectional view illustrating another part of the first embodiment of a method for manufacturing a bonded semiconductor wafer according to the present invention.
FIG. 7 is a schematic cross-sectional view illustrating another part of the first embodiment of a method for manufacturing a bonded semiconductor wafer according to the present invention.
FIG. 8 is a schematic cross-sectional view illustrating another part of the first embodiment of a method for manufacturing a bonded semiconductor wafer according to the present invention.
FIG. 9 is a schematic cross-sectional view illustrating another part of the first embodiment of a method for manufacturing a bonded semiconductor wafer according to the present invention.
FIG. 10 is a schematic cross-sectional view illustrating another part of the first embodiment of a method for manufacturing a bonded semiconductor wafer according to the present invention.
FIG. 11 is a schematic cross-sectional view illustrating another part of the first embodiment of a method for manufacturing a bonded semiconductor wafer according to the present invention.
FIG. 12 is a schematic cross-sectional view of an example of a bonded semiconductor wafer obtainable in the first embodiment of a method for manufacturing the bonded semiconductor wafer according to the present invention.
FIG. 13 is a schematic cross-sectional view illustrating another part of the second embodiment of a method for manufacturing a bonded semiconductor wafer according to the present invention.
FIG. 14 is a schematic cross-sectional view illustrating another part of the second embodiment of a method for manufacturing a bonded semiconductor wafer according to the present invention.
FIG. 15 is a schematic cross-sectional view illustrating another part of the second embodiment of a method for manufacturing a bonded semiconductor wafer according to the present invention.
FIG. 16 is a schematic cross-sectional view illustrating another part of the second embodiment of a method for manufacturing a bonded semiconductor wafer according to the present invention.
FIG. 17 is a schematic cross-sectional view illustrating another part of the second embodiment of a method for manufacturing a bonded semiconductor wafer according to the present invention.
FIG. 18 is a schematic cross-sectional view illustrating another part of the second embodiment of a method for manufacturing a bonded semiconductor wafer according to the present invention.
FIG. 19 is a schematic cross-sectional view illustrating another part of the second embodiment of a method for manufacturing a bonded semiconductor wafer according to the present invention.
FIG. 20 is a schematic cross-sectional view illustrating another part of the second embodiment of a method for manufacturing a bonded semiconductor wafer according to the present invention.
FIG. 21 is a schematic cross-sectional view illustrating another part of the second embodiment of a method for manufacturing a bonded semiconductor wafer according to the present invention.
FIG. 22 is a schematic cross-sectional view illustrating another part of the second embodiment of a method for manufacturing a bonded semiconductor wafer according to the present invention.
FIG. 23 is a schematic cross-sectional view illustrating another part of the second embodiment of a method for manufacturing a bonded semiconductor wafer according to the present invention.
FIG. 24 is a schematic cross-sectional view of an example of a bonded semiconductor wafer obtainable in the second embodiment of a method for manufacturing the bonded semiconductor wafer according to the present invention.
FIG. 25 is a schematic cross-sectional view illustrating a part of a method for manufacturing a bonded semiconductor wafer of Comparative Example.
FIG. 26 is a schematic cross-sectional view illustrating another part of a method for manufacturing a bonded semiconductor wafer of Comparative Example.
FIG. 27 is a schematic cross-sectional view illustrating another part of a method for manufacturing a bonded semiconductor wafer of Comparative Example.
FIG. 28 is a schematic cross-sectional view illustrating another part of a method for manufacturing a bonded semiconductor wafer of Comparative Example.
FIG. 29 is a schematic cross-sectional view illustrating another part of a method for manufacturing a bonded semiconductor wafer of Comparative Example.
FIG. 30 is a schematic cross-sectional view illustrating another part of a method for manufacturing a bonded semiconductor wafer of Comparative Example.
FIG. 31 is a schematic cross-sectional view illustrating another part of a method for manufacturing a bonded semiconductor wafer of Comparative Example.
FIG. 32 is a schematic cross-sectional view of an example of a bonded semiconductor wafer obtainable in a method for manufacturing the bonded semiconductor wafer of Comparative Example.
FIG. 33 is a graph illustrating a relation between dice design size and light-emitting efficacy regarding Examples 1 and 2, and Comparative Example.

### DESCRIPTION OF EMBODIMENTS

Hereinafter, the present invention will be described in detail; however, the present invention is not limited thereto.

The present invention is a method for manufacturing a bonded semiconductor wafer, the method comprising the steps of:
epitaxially growing an etching stop layer on a starting substrate;
producing an epitaxial wafer by epitaxially growing an epitaxial layer having a compound semiconductor functional layer on the etching stop layer;
forming an isolation groove to form a device in the compound semiconductor functional layer by a dry etching method;
performing roughening etching on a surface of the epitaxial layer, being the opposite side of the starting substrate, thereby making surface roughness thereon to have 0.1 um or more in an arithmetic average roughness Ra;
bonding a visible light-transmissive substrate of a different material from a material of the epitaxial layer to the surface opposite to the starting substrate of the epitaxial layer via a visible light-transmissive thermosetting bonding material; and
removing the starting substrate.

Hereinafter, aspects of the present invention are described exemplifying the first embodiment and the second embodiment. Similar components in each embodiment are described with the same reference signs in the drawings. Moreover, overlapping descriptions are partially omitted.

### [First Embodiment]

First, the first embodiment is described. This embodiment is an aspect in which roughening etching is performed before forming an isolation groove.

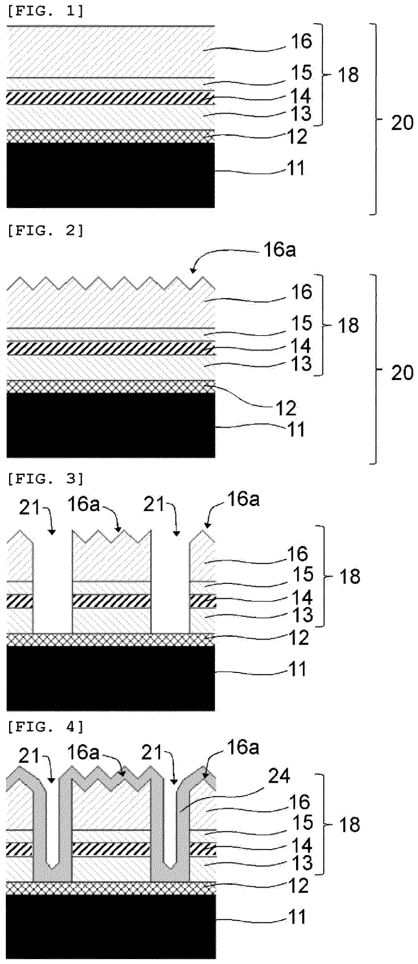

To begin with, as shown in FIG. 1, epitaxial growth is performed sequentially on a starting substrate 11, and each layer is formed to produce an epitaxial wafer 20. This produces the epitaxial layer, which has an etching stop layer 12 and a compound semiconductor functional layer 18. More specifically, epitaxial growth of each layer can be performed as described below.

As shown in FIG. 1, the etching stop layer 12 is epitaxially grown on the first conductivity-type starting substrate 11 made of, for example, GaAs. The etching stop layer 12 can be formed, for example, after laminating a first conductivity-type GaAs buffer layer, followed by growing a first conductivity-type GaₓIn₁₋ₓP (0.4≤x≤0.6) first etching stop layer of, e.g., 0.3 um, and a first conductivity-type GaAs second etching stop layer of, e.g., 0.3 um. Moreover, the epitaxial wafer 20 is provided with a light-emitting device structure as the semiconductor functional layer (epitaxial functional layer) 18 in which, for example, a first conductivity-type (Al_{y}Ga_{1-y})ₓIn₁₋ₓP (0.4≤x≤0.6, 0<y≤1) first cladding layer 13 of, e.g., 1.0 um, a non-doped (Al_{y}Ga_{1-y})ₓIn₁₋ₓP (0.4≤x≤0.6, 0≤y≤0.6) active layer 14, a second conductivity-type (Al_{y}Ga_{1-y})ₓIn₁₋ₓP (0.4≤x≤0.6, 0<y≤1) second cladding layer 15 of, e.g., 1.0 um, a second conductivity-type GaInP intermediate layer (not shown) of, e.g., 0.1 um, a second conductivity-type GaP window layer 16 of, e.g., 4 um are sequentially grown on the etching stop layer 12. At this point, from the AlGaInP first cladding layer 13 to the AlGaInP second cladding layer 15 is referred to as a double-hetero (DH) structure part (FIG. 1). In addition, the materials of the semiconductor functional layer (epitaxial functional layer) 18 are not limited to these, and the materials having the light-emitting device structure may be used as described above.

Next, as shown in FIG. 2, by performing the roughening etching (frost) treatment to a surface of the epitaxial layer of the epitaxial wafer 20 (the opposite surface to the starting substrate), micro irregularities are formed on the surface of the epitaxial layer of the epitaxial wafer 20 to make surface roughness 0.1 um or more in an arithmetic average roughness Ra (FIG. 2). The reason why the surface roughness is made to 0.1 um or more in Ra here is that, by roughening a light extraction surface to increase a scattering at an interface between a semiconductor surface and atmosphere, total reflection at the interface due to a refractive index difference is reduced, thereby increasing external quantum efficiency. This is because even if the roughness is lower than this Ra value, a scattering effect, in other words, an external quantum efficiency-enhancing effect, does not vanish; however, the effect thereof reduces significantly. In FIG. 2, a rough surface 16a positioned on a wafer surface portion of the window layer 16 is shown. This roughening etching treatment is preferably performed using a solution mixed with at least two of acetic acid solution, hydrofluoric acid solution, and iodine solution.

Next, as shown in FIG. 3, an isolation groove 21 is formed by a dry etching method to form the device in the compound semiconductor functional layer 18. More specifically, a resist mask or a hard mask is formed by a photolithography method, and then etching is performed from the window layer 16 to the first cladding layer 13 by a dry etching method using chlorine-based plasma, for example, to perform device isolation step for forming a device isolation groove 21 (FIG. 3).

In the present invention, as the luminance decrease of the smaller device size can be suppressed, one side of the device can be 100 um or less (i.e., the size of the light-emitting device produced is also equivalent) when this isolation groove 21 is formed. In particular, one side of this device can be 50 um or less. In this case, a design size of the device is also referred to as a dice design size.

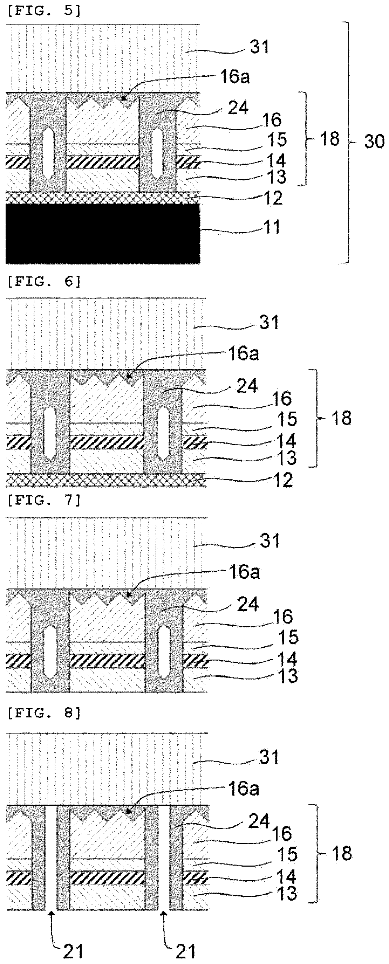

Next, as shown in FIG. 4 and FIG. 5, a visible light-transmissive substrate 31 of a different material from a material of the epitaxial layer is bonded to the surface opposite to the starting substrate 11 of the epitaxial wafer 20 via a visible light-transmissive thermosetting bonding material 24. More specifically, for example, the following is the case. First, as shown in FIG. 4, the epitaxial wafer 20 is spin-coated thereon with, for example, benzocyclobutene (BCB) as the thermosetting bonding material 24 having visible light-transmissivity (FIG. 4), and then by facing, superimposing, and thermo-compressing with, for example, a sapphire wafer 31 which is a dissimilar substrate having visible light-transmissivity, a bonded substrate 30 is produced, in which the epitaxial wafer 20 and the sapphire wafer 31 are bonded via the BCB which is the visible light-transmissive thermosetting bonding material 24. When the BCB is coated by spin-coating, a film thickness can be, for example, 0.01 um or more and 0.6 um or less (FIG. 5).

In addition, as shown in FIG. 4 and FIG. 5, the visible light-transmissive thermosetting bonding material 24 may be coated inside the isolation groove 21, but adhesion of the visible light-transmissive substrate 31 to the epitaxial wafer 20 has no particular problem.

Although the thickness of the BCB film, being the visible light-transmissive thermosetting bonding material 24, is not limited to this thickness, a more desirable range is present when the BCB film is formed by spin-coating, etc. The thickness of the visible light-transmissive thermosetting bonding material 24 (in particular, BCB), when in the preferred range, can make the thickness distribution of the bonded material relatively small, and the area yield after the bonding process tends to be improved. When the thickness of the visible light-transmissive thermosetting bonding material 24 (in particular, BCB) is designed to have 0.01 um or more, for example, a bonding area yield of 70 % or more can be achieved. When this thickness is 0.05 um or more, for example, an area yield of 90 % or more can be achieved. Moreover, this film thickness is sufficient at 0.6 um or less, as described above.

Furthermore, the dissimilar substrate, being the visible light-transmissive substrate 31, is not limited to sapphire; any material can be selected as long as its flatness is secured, and the absorptivity for an excimer laser light is low. In addition to sapphire, quartz, glass, SiC, LiTaO₃, and LiNbO₃ can be selected.

In addition, the visible light-transmissive thermosetting bonding material is not limited to BCB; any material can be selected as long as the material has thermosetting properties. In addition to BCB, the material can be any one or more of silicone resin, epoxy resin, spin-on-glass (SOG), polyimide (PI), or fluororesin. As fluororesin, amorphous fluororesin, such as CYTOP (registered trademark) can be used.

Then, as shown in FIG. 6 and FIG. 7, the starting substrate 11 is removed, more specifically, in the following manner. As in the example described above, when the GaAs substrate is used as the starting substrate 11, as shown in FIG. 6, the substrate is removed by wet etching with ammonia-hydrogen peroxide mixture (a mixed solution of ammonia and hydrogen peroxide) (FIG. 6), and then the GaInP first etching stop layer out of the etching stop layer 12 is exposed. Then, as shown in FIG. 7, the etchant is switched to a hydrochloric acid-based etchant to selectively remove the GaInP first etching stop layer out of the etching stop layer 12, and then the GaAs second etching stop layer out of the etching stop layer 12 is exposed. Then, the etchant is switched to a peroxide sulfuric-based etchant (a mixed solution of sulfuric acid and hydrogen peroxide) to selectively remove the GaAs second etching stop layer, thereby exposing the first cladding layer 13. By performing the above processes, an epitaxial bonded substrate that retains only the DH layer and the window layer can be produced (FIG. 7).

As described above, the bonded semiconductor wafer can be manufactured. The bonded semiconductor wafer, shown in FIG. 7, can be the wafer for a micro-LED structure having a light-emitting layer and the window layer. In addition, as shown below, electrodes, etc., of each device can be subsequently formed.

Next, as shown in FIG. 8, a resist mask or a hard mask is formed by a photolithography method. Then, a part of the visible light-transmissive thermosetting bonding material 24 (BCB portion) existing in the device isolation groove 21 is etched by the dry etching method using, for example, fluorine-based plasma to form an island-shaped pattern (FIG. 8).

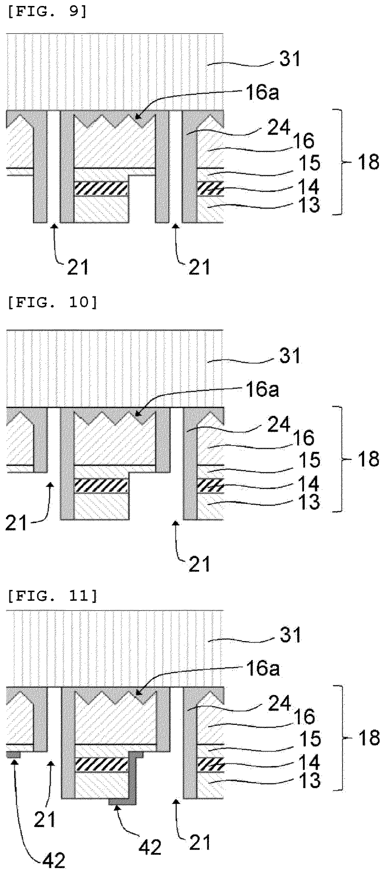

Then, as shown in FIG. 9, a resist mask or a hard mask is formed by the photolithography method, and from the first cladding layer 13 to the second cladding layer 15 is etched by the dry etching method using, for example, chlorine-based plasma, thereby exposing a part of the second cladding layer 15 (FIG. 9).

In addition, FIG. 9 shows a state in which the second cladding layer 15 is etched to the middle portion of the layer; however, an etched depth is not limited to this depth, and any depth is sufficient as long as the etching passes through the active layer 14. The same effects can be obtained, for example, in the state where the active layer 14 is completely eliminated and the second cladding layer 15 is almost unetched, or in the state where the second cladding layer 15 portion is completely etched and the GaP window layer 16 is exposed.

Next, the visible light-transmissive thermosetting bonding material 24 (BCB-cured portion) in a spike shape, as shown in FIG. 10, is removed physically by methods, such as liftoff (FIG. 10). For example, liquid flow with a pressure of about 5 kgf/cm² can remove the spike-shaped BCB-cured portion, but the method is not limited to this method, and an ashing method may be used, or an RIE method may be used. In the ashing method and the RIE (reactive ion etching) method, although the BCB-cured film is eroded isotropically, it is possible to remove only the spike-shaped BCB-cured portion due to the higher eroding speed of the spiked-shaped BCB-cured portion than that of the film-shaped BCB-cured portion, when time condition is adjusted.

Then, as shown in FIG. 11, a passivation (PSV) film 42, such as SiO₂, is formed on the surface to coat a device separation edge, and a side of the exposed active layer, and then a PSV pattern film processed to expose a part of the first clad and a part of the second clad is produced (FIG. 11).

Note that the passivation film 42 is not limited to the SiO₂ film, and any material can be selected as long as the material has an insulating property.

For example, the passivation film 42 can be formed by a P-CVD method (plasma CVD) using TEOS (tetraethoxysilane) and O₂. However, the method is not limited to this method, and any method can be selected as long as the passivation film 42 is formed. For example, the film may also be formed by methods, such as a sputtering method, a PLD method (Pulsed Laser Deposition), an ALD method (Atomic layer deposition), and a sol-gel method.

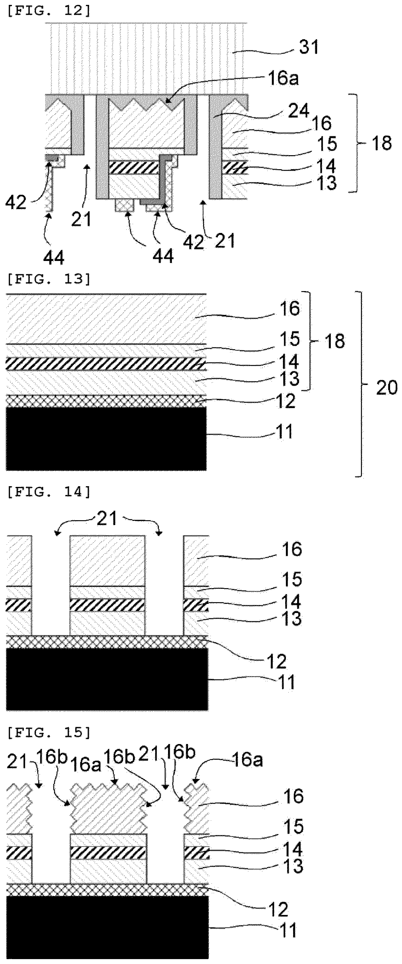

Next, electrodes 44 are formed on the exposed portion of the passivation film 42, as shown in FIG. 12, and heat treatment is performed to realize an ohmic contact (FIG. 12) .

Moreover, Au-based material can be adopted for the electrodes 44, and when the electrode is provided near a P-type layer, an Au metallic layer containing Be or Zn is preferably provided in the vicinity (within 0.5 um) of the semiconductor layer. When the electrode is provided near an N-type layer, an Au metallic layer containing Ge or Si is preferably provided in the vicinity (within 0.5 um) of the semiconductor layer.

Although a design is exemplified here, in which a lead layer is provided with the electrode 44 in contact with the second cladding layer 15 and up to the height of the first cladding layer 13, the design is not limited to the design having a lead structure. The same effect can be obtained from a structure without providing the lead structure, in which the thickness of the electrode 44 in contact with the second cladding layer 15 is designed to be thicker than that of the electrode on the first cladding layer 13 to reduce a difference in levels.

### [Second Embodiment]

Next, the second embodiment of the present invention is described. This embodiment is an aspect in which roughening etching is performed after forming an isolation groove.

To begin with, as shown in FIG. 13, as in the first embodiment, epitaxial growth is performed sequentially on a starting substrate 11, and each layer is formed to produce an epitaxial wafer 20 having an epitaxial layer including an etching stop layer 12 and a compound semiconductor functional layer 18. More specifically, epitaxial growth of each layer can be performed as described below.

First, as shown in FIG. 13, for example, on a GaAs starting substrate 11 of the first conductivity-type, the etching stop layer 12 is epitaxially grown. The etching stop layer 12 can be formed, for example, after laminating a first conductivity-type GaAs buffer, followed by growing a first conductivity-type GaₓIn₁₋ₓP (0.4≤x≤0.6) first etching stop layer of, e.g., 0.3 um, and a first conductivity-type GaAs second etching stop layer of, e.g., 0.3 um. Moreover, the epitaxial wafer 20 is provided with a light-emitting device structure as the semiconductor functional layer (epitaxial functional layer) 18 in which, for example, a first conductivity-type (Al_{y}Ga_{1-y})ₓIn₁₋ₓP (0.4≤x≤0.6, 0<y≤1) first cladding layer 13 of, e.g., 1.0 um, a non-doped (Al_{y}Ga_{1-y})ₓIn₁₋ₓP (0.4≤x≤0.6, 0≤y≤0.6) active layer 14, a second conductivity-type (Al_{y}Ga_{1-y})ₓIn₁₋ₓP (0.4≤x≤0.6, 0<y≤1) second cladding layer 15 of, e.g., 1.0 um, a second conductivity-type GaInP intermediate layer (not shown) of, e.g., 0.1 um, and a second conductivity-type GaP window layer 16 of, e.g., 4 µm, are sequentially grown on the etching stop layer 12. At this point, from the AlGaInP first cladding layer 13 to the AlGaInP second cladding layer 15 is referred to as a double-hetero (DH) structure (FIG. 13). In addition, the materials of the compound semiconductor functional layer (epitaxial functional layer) 18 are not limited to these and any those have light-emitting device structure may be used.

Next, as shown in FIG. 14, the isolation groove is formed by a dry etching method to form the device in the compound semiconductor functional layer. More specifically, a resist mask or a hard mask is formed by a photolithography method, and then etching is performed from the window layer 16 to the first cladding layer 13 by a dry etching method using chlorine-based plasma, for example, to perform device isolation step for forming a device isolation groove 21 (FIG. 14).

In the present invention, as the luminance decrease of the smaller device size can be suppressed, one side of the device can be 100 µm or less (i.e., the size of the light-emitting device produced is also equivalent) when this isolation groove 21 is formed. In particular, one side of this device can be 50 µm or less.

Next, as shown in FIG. 15, by performing the roughening etching (frost) treatment to a surface of the epitaxial layer (the surface of device isolation dice), where the device isolation groove 21 is formed, micro irregularities of 0.1 um or more in an arithmetic average roughness Ra are formed on the surface of the epitaxial layer of the epitaxial wafer 20 (the surface of the window layer 16 of dice) (FIG. 15). In FIG. 15, a rough surface 16a positioned on a wafer surface portion of the window layer 16 and a rough surface 16b positioned on a side of the window layer 16 are shown. This roughening etching treatment is preferably performed using a solution mixed with at least two of acetic acid solution, hydrofluoric acid solution, and iodine solution.

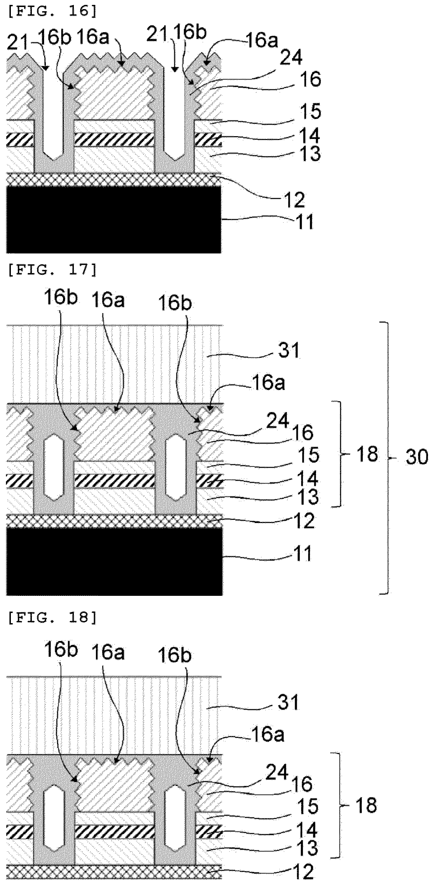

Next, as shown in FIG. 16 and FIG. 17, a visible light-transmissive substrate 31 of a different material from a material of the epitaxial layer is bonded to the surface opposite to the starting substrate 11 of the epitaxial wafer 20 via a visible light-transmissive thermosetting bonding material 24. More specifically, for example, in the following manner. First, as shown in FIG. 16, the epitaxial wafer 20 having dice with roughened treatment is spin-coated thereon with, for example, benzocyclobutene (BCB) as the thermosetting bonding material 24 having visible light-transmissivity (FIG. 16), and by facing, superimposing, and thermo-compressing with, for example, a sapphire wafer 31 which is a dissimilar substrate having visible light-transmissivity, a bonded substrate 30 is produced, in which the epitaxial wafer 20 and the sapphire wafer 31 are bonded via the BCB. When the BCB is coated by spin-coating, a film thickness can be 0.6 um (FIG. 17).

Furthermore, the dissimilar substrate, being the visible light-transmissive substrate 31, is not limited to sapphire, but any material can be selected as long as the material has secured flatness and a low absorptivity to excimer laser light. In addition to sapphire; quartz, glass, SiC, LiTaO₃, and LiNbO₃ can be selected.

In addition, the visible light-transmissive thermosetting bonding material is not limited to BCB; any material can be selected as long as the material has thermosetting properties. In addition to BCB, the material can be any one or more of silicone resin, epoxy resin, spin-on-glass (SOG), polyimide (PI), or fluororesin. As fluororesin, amorphous fluororesin, such as CYTOP (registered trademark), can be used.

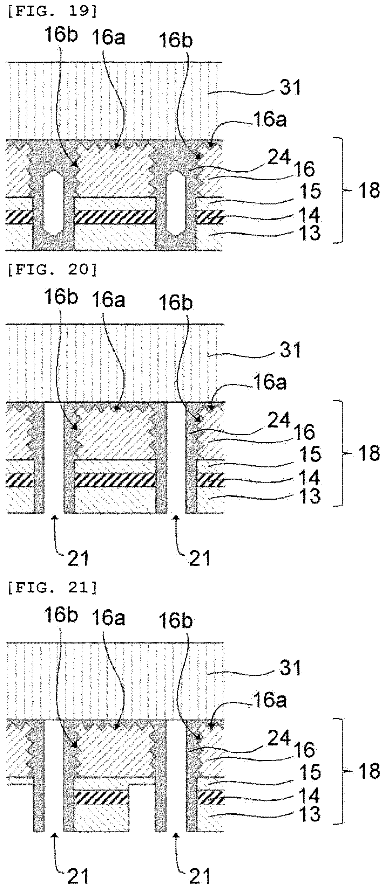

Then, as shown in FIG. 18 and FIG. 19, the starting substrate 11 is removed, more specifically in the following manner. As in the example described above, when the GaAs substrate is used as the starting substrate 11, as shown in FIG. 18, the substrate is removed by wet etching with ammonia-hydrogen peroxide mixture (a mixed solution of ammonia and hydrogen peroxide) (FIG. 18), and then the GaInP first etching stop layer out of the etching stop layer 12 is exposed. Then, as shown in FIG. 19, the etchant is switched to a hydrochloric acid-based etchant to selectively remove the GaInP first etching stop layer out of the etching stop layer 12, and then the GaAs second etching stop layer out of the etching stop layer 12 is exposed. Then, the etchant is switched to a peroxide sulfuric-based etchant (a mixed solution of sulfuric acid and hydrogen peroxide) to selectively remove the GaAs second etching stop layer, thereby exposing the first cladding layer 13. By performing the above processes, an epitaxial bonded substrate that retains only the DH layer and the window layer can be produced (FIG. 19).

As described above, the bonded semiconductor wafer can be manufactured. The bonded semiconductor wafer, shown in FIG. 19, can be the wafer for a micro-LED structure having a light-emitting layer and the window layer. In addition, as shown below, electrodes, etc., of each device can be subsequently formed.

Next, as shown in FIG. 20, a resist mask or a hard mask is formed by a photolithography method. Then, a part of the visible light-transmissive thermosetting bonding material 24 (BCB portion), existing in the device isolation groove 21, is etched by the dry etching method using fluorine-based plasma to form an island-shaped pattern (FIG. 20).

Then, as shown in FIG. 21, a resist mask or a hard mask is formed by the photolithography method, and from the first cladding layer 13 to the second cladding layer 15 is etched by the dry etching method using, for example, chlorine-based plasma to expose a part of the second cladding layer 15 (FIG. 21).

In addition, FIG. 21 shows a state in which the second cladding layer 15 is etched to the middle portion of the layer; however, an etched depth is not limited to this depth, and the same effect can be obtained as long as the etching passes through the active layer 14. The same effects can be obtained, for example, in the state where the active layer 14 is completely eliminated and the second cladding layer 15 is almost unetched, or in the state where the second cladding layer 15 portion is completely etched and the GaP window layer 16 is exposed.

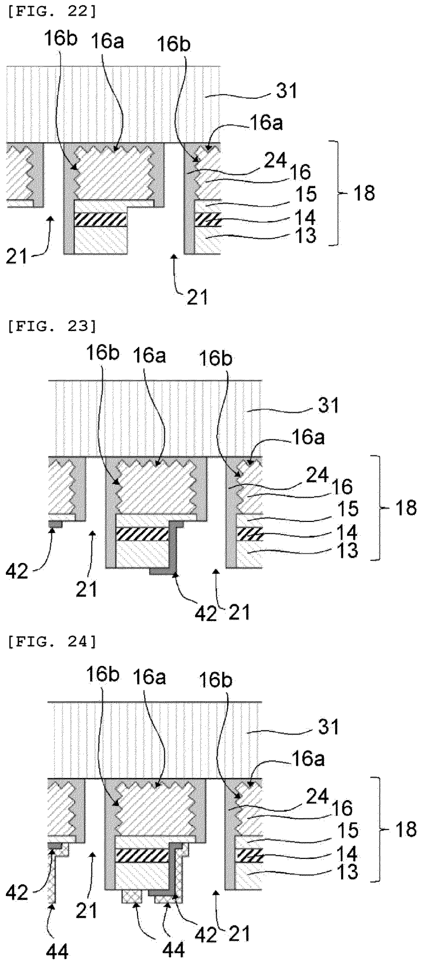

Next, the visible light-transmissive thermosetting bonding material 24 (BCB-cured portion) in a spike shape, as shown in FIG. 22, is removed physically by a method, such as a liftoff (FIG. 22). For example, liquid flow with a pressure of about 5 kgf/cm² can remove the spike-shaped BCB-cured portion but the method is not limited to this method, and an ashing method may be used, or an RIE method may be used. In the ashing method and the RIE method, although the BCB-cured film is eroded isotropically, it is possible to remove only the spike-shaped BCB-cured portion due to the higher eroding speed of the spiked-shaped BCB-cured portion than that of the film-shaped BCB-cured portion, when time condition is adjusted.

Then, as shown in FIG. 23, a passivation (PSV) film 42, such as SiO₂, is formed on the surface to coat a device separation edge, and a side of the exposed active layer, and then a PSV pattern film processed to expose a part of the first clad and a part of the second clad is produced (FIG. 23).

Note that the passivation film 42 is not limited to the SiO₂ film, and any material can be selected as long as the material has an insulating property.

For example, the passivation film 42 can be formed by a P-CVD method using TEOS and O₂. However, the method is not limited to this method and any method can be selected as long as the passivation film 42 can be formed. For example, the same effect can be obtained from forming by methods such as a sputtering method, a PLD method, an ALD method, and a sol-gel method.

Next, electrodes 44 are formed on the exposed portion of the passivation film 42, as shown in FIG. 24, and heat treatment is performed to realize an ohmic contact (FIG. 24) .

Moreover, Au-based material can be adopted for the electrode 44, and when the electrode 44 is provided near a P-type layer, an Au metallic layer containing Be or Zn is preferably provided in the vicinity (within 0.5 um) of the semiconductor layer. When the electrode 44 is provided near an N-type layer, an Au metallic layer containing Ge or Si is preferably provided in the vicinity (within 0.5 um) of the semiconductor layer.

Although a design is exemplified here, in which a lead layer is provided with the electrode 44 in contact with the second cladding layer 15 and up to the height of the first cladding layer 13, the design is not limited to the design having a lead structure. The same effect can be obtained from a structure without providing the lead structure, in which the thickness of electrode 44 in contact with the second cladding layer 15 is designed to be thicker than that of electrode 44 on the first cladding layer 13 to reduce a difference in levels.

### EXAMPLE

Hereinafter, the present invention will be described in detail with reference to Examples and Comparative Example. However, the present invention is not limited thereto.

### (Example 1)

A bonded semiconductor wafer was manufactured in accordance with the first embodiment.

First, as shown in FIG. 1, after laminating a first conductivity-type GaAs buffer layer on a first conductivity-type starting substrate 11, an etching stop layer 12 was formed thereon by epitaxially growing a first conductivity-type GaₓIn₁₋ₓP (0.4≤x≤0.6) first etching stop layer of 0.3 um, and a first conductivity-type GaAs second etching stop layer of 0.3 um. Moreover, an epitaxial wafer 20 was provided with a light-emitting device structure as a compound semiconductor functional layer (epitaxial functional layer) 18 in which a first conductivity-type (Al_{y}Ga_{1-y})ₓIn₁₋ₓP (0.4≤x≤0.6, 0<y≤1) first cladding layer 13 of 1.0 um, a non-doped (Al_{y}Ga_{1-y})ₓIn₁₋ₓP (0.4≤x≤0.6, 0≤y≤0.6) active layer 14, a second conductivity-type (Al_{y}Ga_{1-y})ₓIn₁₋ₓP (0.4≤x≤0.6, 0<y≤1) second cladding layer 15 of 1.0 um, a second conductivity-type GaInP intermediate layer (not shown) of 0.1 um, a second conductivity-type GaP window layer 16 of 4 µm, were sequentially grown (FIG. 1).

Next, as shown in FIG. 2, by performing roughening etching (frost treatment) on the epitaxial wafer 20, micro irregularities of Ra = 1.12 um in an arithmetic average roughness were formed on a surface of the epitaxial layer (FIG. 2). This roughening etching (frost treatment) was performed using a mixed acid containing acetic acid, hydrofluoric acid, nitric acid, and iodine.

Next, as shown in FIG. 3, a resist mask was formed by a photolithography method, and then etching was performed from the first cladding layer 13 to the GaP window layer 16 by a dry etching method using chlorine-based plasma to perform a device isolation step for forming a device isolation groove 21 (FIG. 3).

Next, as shown in FIGS. 4 and 5, the epitaxial wafer 20 was spin-coated thereon with benzocyclobutene (BCB) as a visible light-transmissive thermosetting bonding material 24 (FIG. 4), and by facing, superimposing, and thermo-compressing with a sapphire wafer (to-be-bonded wafer) which was a visible light-transmissive substrate 31, an epitaxial bonded substrate was produced, in which the epitaxial wafer 20 and the sapphire wafer 31 were bonded via the BCB 24 (FIG. 5). When the BCB 24 was coated by spin-coating, a film thickness was 0.6 µm.

Then, as shown in FIG. 6, the GaAs starting substrate 11 was removed by wet etching with ammonia-hydrogen peroxide mixture (a mixed solution of ammonia and hydrogen peroxide) (FIG. 6), and then the GaInP first etching stop layer out of the etching stop layer 12 was exposed. Then, as shown in FIG. 7, the etchant was switched to a hydrochloric acid-based etchant to selectively remove the GaInP first etching stop layer out of the etching stop layer 12, and then the GaAs second etching stop layer was exposed. Then, the etchant is switched to a peroxide sulfuric-based etchant (a mixed solution of sulfuric acid and hydrogen peroxide) to selectively remove the GaAs second etching stop layer, thereby removing the etching stop layer 12 and exposing the first cladding layer 13 (FIG. 7).

Next, as shown in FIG. 8, a resist mask was formed by a photolithography method, and then a part of the BCB portion 24, existing in the device isolation groove 21, was etched by the dry etching method using fluorine-based plasma to form an island-shaped pattern (FIG. 8).

Then, as shown in FIG. 9, a resist mask was formed by the photolithography method, and from the first cladding layer 13 to the second cladding layer 15 was etched by the dry etching method using chlorine-based plasma to expose a part of the second cladding layer 15 (FIG. 9).

Next, as shown in FIG. 10, the BCB-cured portion in a spike shape was removed by liquid flow with a pressure of 5 kgf/cm² (FIG. 10). Then, as shown in FIG. 11, a passivation (PSV) film 42 made of SiO₂ was formed on the surface to coat a device separation edge, and a side of the exposed active layer 14, and then a PSV pattern film processed to expose a part of the first cladding layer 13 and a part of the second cladding layer 15 was produced (FIG. 11). The passivation film 42 was formed by a P-CVD method using TEOS and O₂.

Next, as shown in FIG. 12, Au-based electrodes 44 were formed on the exposed portion of the passivation film 42, and heat treatment was performed to make ohmic contact (FIG. 12).

### (Example 2)

A bonded semiconductor wafer was manufactured in accordance with the second embodiment.

First, as shown in FIG. 13, after laminating a first conductivity-type GaAs buffer layer on a first conductivity-type GaAs starting substrate 11, an etching stop layer 12 was formed thereon by epitaxially growing a first conductivity-type GaₓIn₁₋ₓP (0.4≤x≤0.6) first etching stop layer of 0.3 um, and a first conductivity-type GaAs second etching stop layer of 0.3 um. Moreover, an epitaxial wafer 20 was provided with a light-emitting device structure as a compound semiconductor functional layer (epitaxial functional layer) 18 in which a first conductivity-type (Al_{y}Ga_{1-y})ₓIn₁₋ₓP (0.4≤x≤0.6, 0<y≤1) first cladding layer 13 of 1.0 um, a non-doped (Al_{y}Ga_{1-y})ₓIn₁₋ₓP (0.4≤x≤0.6, 0≤y≤0.6) active layer 14, a second conductivity-type (Al_{y}Ga_{1-y})ₓIn₁₋ₓP (0.4≤x≤0.6, 0<y≤1) second cladding layer 15 of 1.0 um, a second conductivity-type GaInP intermediate layer (not shown) of 0.1 um, and a second conductivity-type GaP window layer 16 of 4 um were sequentially grown (FIG. 13).

Next, as shown in FIG. 14, a resist mask was formed by a photolithography method, and then etching was performed from the first cladding layer 13 to the GaP window layer 16 by a dry etching method using chlorine-based plasma to perform a device isolation step for forming a device isolation groove 21 (FIG. 14).

Next, as shown in FIG. 15, roughening etching was performed on a surface of the epitaxial layer of the epitaxial wafer 20. Specifically, the roughening etching (frost treatment) was applied on device isolation dice where the device isolation groove 21 was formed, and micro irregularities of Ra = 1.08 um on a surface of the GaP layer 16 of the dice and that of Ra = 0.87 um on a side of the Gap layer were formed (FIG. 15). In this case, the roughening etching (frost treatment) was performed using a mixed acid containing acetic acid, hydrofluoric acid, nitric acid, and iodine.

Next, as shown in FIG. 16, benzocyclobutene (BCB), being a visible light-transmissive thermosetting bonding material 24, was spin-coated on the epitaxial wafer 20 having the dice being applied roughening etching (frost treatment) (FIG. 16). Then, as shown in FIG. 17, by facing, superimposing and thermo-compressing with a sapphire wafer (to-be-bonded wafer) which is a visible light-transmissive substrate 31, an epitaxial bonded substrate was produced, in which the epitaxial wafer 20 and the sapphire wafer 31 were bonded via the BCB 24 (FIG. 17). When the BCB 24 was coated by spin-coating, a film thickness was 0.6 µm.

Then, as shown in FIG. 18 and FIG. 19, the GaAs starting substrate 11 was removed by wet etching with ammonia-hydrogen peroxide mixture (a mixed solution of ammonia and hydrogen peroxide) (FIG. 18), and then the first etching stop layer out of the etching stop layer 12 was exposed, then, the etchant was switched to remove the second etching stop layer out of the etching stop layer 12, thereby removing the etching stop layer 12 and exposing the first cladding layer 13 (FIG. 19).

Next, as shown in FIG. 20, a resist mask was formed by a photolithography method, and then a part of the BCB portion 24, existing in the device isolation groove 21, was etched by the dry etching method using fluorine-based plasma to form an island-shaped pattern (FIG. 20).

Then, as shown in FIG. 21, a resist mask was formed by the photolithography method, and from the first cladding layer 13 to the second cladding layer 15 was etched by the dry etching method using chlorine-based plasma to expose a part of the second cladding layer 15 (FIG. 21).

Next, as shown in FIG. 22, the BCB-cured portion in a spike shape was removed by liquid flow with a pressure of about 5 kgf/cm² (FIG. 22). Then, as shown in FIG. 23, a passivation (PSV) film 42 made of SiO₂ was formed on the surface to coat a device separation edge, and a side of the exposed active layer 14, and then a PSV pattern film processed to expose a part of the first cladding layer 13 and a part of the second cladding layer 15 was produced (FIG. 23).

Next, as shown in FIG. 24, Au-based electrodes 44 were formed on the exposed portion of the passivation film 42, and heat treatment was performed to make an ohmic contact (FIG. 24).

### (Comparative Example)

An example is shown as Comparative Example in which roughening etching is not performed on a surface of an epitaxial layer.

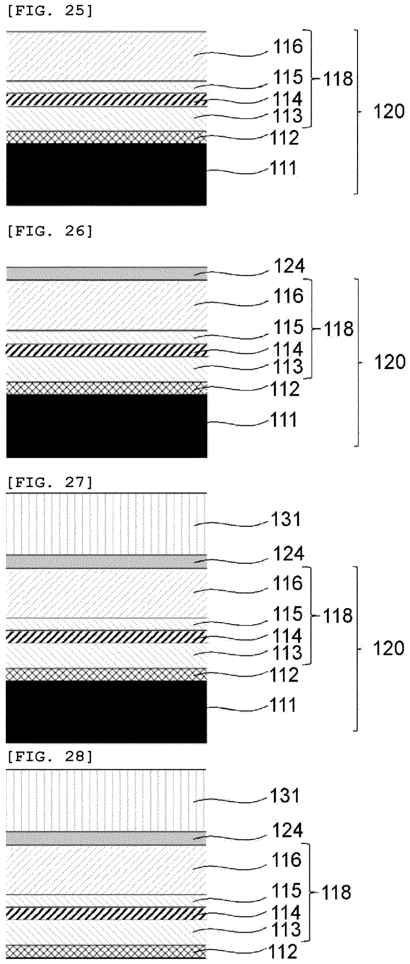

First, as shown in FIG. 25, after laminating a first conductivity-type GaAs buffer layer on a first conductivity-type GaAs starting substrate 111, an etching stop layer 112 was formed thereon by epitaxially growing a first conductivity-type GaₓIn₁₋ₓP (0.4≤x≤0.6) first etching stop layer of 0.3 um, and a first conductivity-type GaAs second etching stop layer of 0.3 um. Moreover, an epitaxial wafer 120 was provided with a light-emitting device structure as a compound semiconductor functional layer (epitaxial functional layer) 118 in which a first conductivity-type (Al_{y}Ga_{1-y})ₓIn₁₋ₓP (0.4≤x≤0.6, 0<y≤1) first cladding layer 113 of 1.0 um, a non-doped (Al_{y}Ga_{1-y})ₓIn₁₋ₓP (0.4≤x≤0.6, 0≤y≤0.6) active layer 114, a second conductivity-type (Al_{y}Ga_{1-y})ₓIn₁₋ₓP (0.4≤x≤0.6, 0<y≤1) second cladding layer 115 of 1.0 um, a second conductivity-type GaInP intermediate layer (not shown) of 0.1 um, and a second conductivity-type GaP window layer 116 of 4 um were sequentially grown (FIG. 25).

Next, as shown in FIGS. 26 and 27, benzocyclobutene (BCB), being a visible light-transmissive thermosetting bonding material 124, was spin-coated on the epitaxial wafer 120 (FIG. 26) and by facing, superimposing, and thermo-compressing with a sapphire wafer, which is a to-be-bonded wafer (visible light-transmissive substrate 131), an epitaxial bonded substrate was produced, in which the epitaxial wafer 120 and the sapphire wafer 131 were bonded via the BCB 124 (FIG. 27). When the BCB 124 was coated by spin-coating, a film thickness was 0.6 µm.

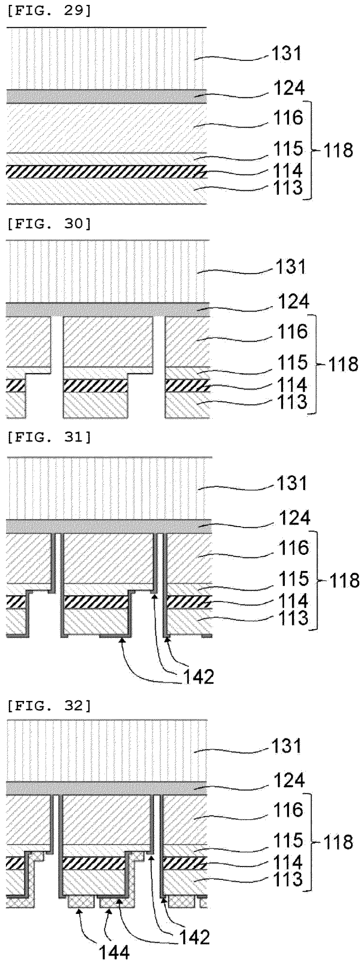

Next, as shown in FIG. 28, the GaAs starting substrate 111 was removed by wet etching (FIG. 28). Then, as shown in FIG. 29, the first etching stop layer was exposed, and then the etchant was switched to remove the second etching stop layer, thereby exposing the first cladding layer, and thus the etching stop layer 112 was removed (FIG. 29), then an epitaxial bonded substrate that retained only the DH layer and the window layer was produced.

Then, as shown in FIG. 30, a mask was formed by a photolithography method, and from the first cladding layer 113 to the GaP window layer 116 was etched to perform a device isolation step for forming the device isolation groove, and an etching step for exposing a part of the second cladding layer 115 (FIG. 30).

Then, as shown in FIG. 31, a passivation (PSV) film 142 made of SiO₂ was formed on the surface to coat a device separation edge and a side of the exposed active layer 114, and then a PSV pattern film processed to expose a part of the first cladding layer 113 and a part of the second cladding layer 115 was produced (FIG. 31).

Next, as shown in FIG. 32, Au-based electrodes 144 were formed on the exposed portion of the passivation film 142, and heat treatment was performed to make an ohmic contact (FIG. 32).

Note that a roughness of a dice surface is Ra = 0.017. With regard to the passivation film 114 and the electrodes 144, the same is true for Examples.

### (Comparison between Examples and Comparative Example)

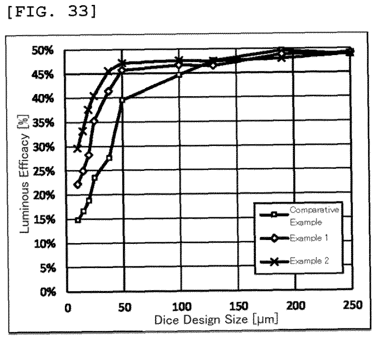

FIG. 33 shows a relation between a micro-LED size (represented by the size of one side of the device) and external quantum efficiency (luminous efficacy) at a current density of 8 [A/cm²]. It is found that, in Comparative Example, as the micro-LED size becomes smaller, the luminous efficacy rapidly drops; however, in Examples 1 and 2, a degree of decrease is moderate.

In particular, it is found that when one side of the device is 100 um or smaller, even 50 um or smaller, a preventive effect for a decrease in luminance, according to the present invention, is significant.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a bonded semiconductor wafer, the method comprising the steps of:
epitaxially growing an etching stop layer on a starting substrate;
producing an epitaxial wafer by epitaxially growing an epitaxial layer having a compound semiconductor functional layer on the etching stop layer;
forming an isolation groove to form a device in the compound semiconductor functional layer by a dry etching method;
performing roughening etching on a surface of the epitaxial layer, being the opposite side of the starting substrate, thereby making surface roughness thereon to have 0.1 um or more in an arithmetic average roughness Ra;
bonding a visible light-transmissive substrate of a different material from a material of the epitaxial layer to the surface opposite to the starting substrate of the epitaxial layer via a visible light-transmissive thermosetting bonding material; and
removing the starting substrate.

2. The method for manufacturing a bonded semiconductor wafer according to claim 1, wherein
the roughening etching is performed before the forming of the isolation groove.

3. The method for manufacturing a bonded semiconductor wafer according to claim 1, wherein
the roughening etching is performed after the forming of the isolation groove.

4. The method for manufacturing a bonded semiconductor wafer according to any one of claims 1 to 3, wherein
one side of the device is 100 um or less by forming the isolation groove in the compound semiconductor functional layer.

5. The method for manufacturing a bonded semiconductor wafer according to any one of claims 1 to 4, wherein
the device is a micro-LED structure having a light emitting layer and a window layer.

6. The method for manufacturing a bonded semiconductor wafer according to any one of claims 1 to 5, wherein
the roughening etching is performed using a solution mixed with at least two of acetic acid solutions, hydrofluoric acid solution, and iodine solution.

7. The method for manufacturing a bonded semiconductor wafer according to any one of claims 1 to 6, wherein
the visible light-transmissive substrate is any one of sapphire, quartz, glass, SiC, LiTaO₃, or LiNbO₃.

8. The method for manufacturing a bonded semiconductor wafer according to any one of claims 1 to 7, wherein
the visible light-transmissive thermosetting bonding material is any one or more materials of benzocyclobutene, silicone resin, epoxy resin, spin-on-glass, polyimide, or fluororesin.

9. The method for manufacturing a bonded semiconductor wafer according to any one of claims 1 to 8, wherein
the visible light-transmissive thermosetting bonding material has a thickness of 0.01 um or more and 0.6 um or less.
